# EUROPÄISCHE PATENTSCHRIFT

(11) **EP 1 915 777 B1**
(45) Veröffentlichungstag und Bekanntmachung des Hinweises auf die Patenterteilung: **20.10.2010**
(21) Anmeldenummer: 06775875.5
(22) Anmeldetag: 10.08.2006
(51) Int. Cl.: H01L 21/768, H01L 23/48

(54) **Halbleitersubstrat und Verfahren zur Herstellung**
Semiconductor substrate and method for the production thereof
Substrat semi-conducteur et procédé de production correspondant

(30) Priorität: 11.08.2005 DE 102005039068
(43) Veröffentlichungstag der Anmeldung: 30.04.2008
(73) Patentinhaber: Fraunhofer-Gesellschaft zur Förderung der angewandten Forschung e.V., 80686 München (DE); Koninklijke Philips Electronics N.V., 5621 BA Eindhoven (NL)
(72) Erfinder: DRABE, Christian, 01099 Dresden (DE); WOLTER, Alexander, 01156 Dresden (DE); STEADMAN, Roger, 52066 Aachen (DE); BERGMANN, Andreas, 01920 Steina (DE); VOGTMEIER, Gereon, 52066 Aachen (DE); DORSCHEID, Ralf, 52066 Aachen (DE)
(74) Vertreter: Pfenning, Meinig & Partner GbR
(86) Internationale Anmeldenummer: PCT/DE2006/001450
(87) Internationale Veröffentlichungsnummer: WO 2007/016924

(56) Entgegenhaltungen:
- EP-A2- 1 306 901
- US-A1- 2003 207 566
- US-A1- 2005 121 768

## Beschreibung

Die Erfindung betrifft Halbleitersubstrate und Verfahren zur Herstellung solcher Halbleitersubstrate. Sie können bei verschiedenen Applikationen eingesetzt werden, wobei eine miniaturisierte Ausbildung erreichbar ist. So können beispielsweise optische Detektoren, wie z.B. Photodioden auf erfindungsgemäßen Halbleitersubstraten angeordnet und elektrisch leitend kontaktiert werden, so dass ihre jeweiligen Messsignale einer elektronischen Auswertung zugeführt und auch eine Abbildung erfasster Bildsignale möglich ist. Insbesondere ist eine erhöhte Anordnungsdichte von Sensoren und anderen Elementen auf einem Träger möglich, so dass bei optischen Detektoren eine höhere Auflösung erreichbar ist. Dabei kann die ganze Oberfläche genutzt werden und die Lücken bzw. Abstände zwischen Sensorelementen oder auch elektrisch ansteuerbaren Elementen/Aktuatoren (z. B. LED's) minimiert zumindest jedoch gegenüber bekannten Lösungen deutlich reduziert werden. Außerdem ist eine höhere Flexibilität für die Anordnung solcher Elemente auf der Vorderseite gegeben.

Häufig werden solche Anordnungen bzw. Arrays auf Halbleitersubstraten, wie beispielsweise Siliziumwafern ausgebildet. Die einzelnen Elemente einer solchen Matrix werden erst durch eine Oberflächenverdrahtung, die einen entsprechenden Platz/Raum erfordert, zum äußeren Rand geführt und dort drahtgebondet.

Um diesem Nachteil entgegenzutreten wurden Versuche unternommen elektrisch leitende Verbindungen in miniaturisierter Form durch ein Halbleitersubstrat hindurch, als so genannte Durchkontaktierung (TWI - Through Wafer Interconnection) auszubilden.

Eine solche Möglichkeit ist in US 6,815,827 B2 beschrieben. Dabei soll ein Siliziumsubstrat von Vorder- und Rückseite bearbeitet werden. In einem ersten Schritt wird eine Grabenstruktur auf der Vorderseite des Halbleitersubstrates durch ein Ätzverfahren ausgebildet, um eine elektrisch leitende Verbindung und eine Isolation zu erreichen. Es wird eine geringe Tiefe von einigen wenigen Mikrometern in die Oberfläche eingeätzt. Nachfolgend wird die Vorderseite mit einer dielektrischen Schicht versehen, die auch in den Vertiefungen ausgebildet ist.

Die so beschichteten Vertiefungen werden dann mit einem Stoff ausgefüllt. Woraufhin auf der Oberfläche Kontaktelemente ausgebildet werden.

Anschließend kann die Rückseite planarisiert und weitere Vertiefungen von der Rückseite des Halbleitersubstrates in dieses hinein ebenfalls durch Ätzen ausgebildet werden, die mit den von der Vorderseite aus ausgebildeten Vertiefungen kommunizieren. Mit einer eine geschlossene Ringstruktur bildenden Vertiefung, die einen Bereich vollständig umschließt wird der innerhalb der Vertiefung liegende Teil des Halbleitersubstrates elektrisch isoliert. Der innen liegende Teil des Halbleitersubstrates bildet die elektrisch leitende Verbindung durch das Halbleitersubstrat und kann an seiner Rückseite mit einem Kontaktelement versehen werden.

Diese Vorgehensweise ist insbesondere dadurch aufwendig da Halbleitersubstrate zweimal einem Ätzverfahren unterzogen werden müssen.

Ein weiterer wesentlicher Nachteil besteht aber in der so nicht gegebenen Möglichkeit, die Herstellung vollständig in CMOS-Technologie durchführen zu können.

In der Rückseite verbleiben Öffnungen, die nicht vollständig ausgefüllt sind. Dies wirkt sich u.a. auch bei einer Handhabung mit vakuum-Manipulatoren nachteilig aus.

Durch die unterschiedlichen Spaltmaße der von Vorder-und Rückseite in das Halbleitersubstrat eingeätzten Vertiefungen wird die mechanische Festigkeit verringert und ein Einsatz insbesondere bei wirkenden hohen Kräften und Beschleunigungen ist stark eingeschränkt.

Aus EP 1 306 901 A1 ist ein System bekannt, bei dem eine elektrische Kontaktierung an Wafern mit Durchbrechungen, die mit elektrisch leitenden Stoffen befüllt und von einer Vorderseite bis zur Rückseite eines Wafers geführt sind, bekannt.

Die US 2003/0207566 A1 betrifft eine elektrische Kontaktierung als Flip-Chip an Halbleitersubstraten, die ebenfalls von der Vorder- zur Rückseite geführt ist.

Es ist daher Aufgabe der Erfindung Halbleitersubstrate zur Verfügung zu stellen, die kostengünstig herstellbar sind, mit denen eine hohe Anordnungsdichte sowie gute elektrische Leitfähigkeit und geschlossene Oberflächen erreichbar sind.

Erfindungsgemäß wird diese Aufgabe mit Halbleitersubstraten, die die Merkmale des Anspruchs 1 aufweisen, gelöst. Sie können mit einem Verfahren nach Anspruch 13 hergestellt werden.

Vorteilhafte Ausgestaltungen und Weiterbildungen der Erfindung können mit den in den untergeordneten Ansprüchen bezeichneten Merkmalen erreicht werden.

Für die Herstellung von erfindungsgemäßen Halbleitersubstraten können beispielsweise Siliziumsubstrate (Si-Wafer) eingesetzt werden, die eine ausreichend große Dicke, beispielsweise bis zu ca. 1000 µm oder auch darunter aufweisen können. Die Auswahl kann unter Berücksichtigung der gewünschten Dicke eines fertig prozessierten Halbleitersubstrates erfolgen. So können solche Substrate in Standardabmessungen eingesetzt und auf eine beliebige Zieldicke bearbeitet werden, die bis in Bereiche sehr geringer Dicken reichen kann.

Ausgehend von der Vorderseite werden unter Verwendung einer Maske mindestens zwei Vertiefungen durch Ätzen, z.B. Trockenätzen mit einer Mindesttiefe von z.B. 200 µm ausgebildet, die zumindest nahezu orthogonal zur Oberfläche der Vorderseite ausgerichtete Innenwände aufweisen oder sich ausgehend von der Vorderseite kontinuierlich konisch verjüngen und quasi "Sacklöcher" bilden. Dabei sind die Innenwände von Vertiefungen generell frei von Absätzen, so dass keine abrupten Änderungen des Spaltmaßes über die Tiefe von Vertiefungen zu verzeichnen sind. Mindestens eine Vertiefung ist im Inneren der anderen Vertiefung angeordnet und von dieser vollständig umschlossen.

Ein so vorbereitetes Halbleitersubstrat wird dann so weiter bearbeitet, dass auf der Vorderseite eine elektrisch isolierende Beschichtung ausgebildet wird, die auch auf der Oberfläche, also den Innenwänden der Vertiefungen ausgebildet ist. Die Beschichtung kann eine Oxidschicht, bevorzugt eine thermisch gebildete Siliziumoxidschicht sein.

Dann werden die Vertiefungen mit einem elektrisch leitenden Stoff vollständig ausgefüllt. Die eine oder auch mehrere innen angeordnete(n) Vertiefung(en) können mit z.B. dotiertem Polysilizium ausgefüllt werden und so wegen der erhöhten elektrischen Leitfähigkeit die elektrisch leitende Verbindung durch das Halbleitersubstrat hindurch nach der Fertigstellung bilden.

Die äußere, die eine oder alle innen angeordnete(n) Vertiefung(en), umschließende Vertiefung, die am fertig prozessierten Element dann den Isolator bildet, wird mit einem elektrisch leitenden Stoff, der Einfachheit halber aber ebenfalls mit dem dotierten Polysilizium ausgefüllt. Dadurch wird die Isolationswirkung durch die elektrisch isolierende Beschichtung der Innenwand dieser Vertiefung erreicht.

Nach dem vollständigen Ausfüllen der Vertiefungen und ggf. deren Planarisierung kann die Vorderseite weiter prozessiert werden, wobei elektrisch leitende Verbindungen zur Füllung in innen angeordneten Vertiefungen vorhanden sein müssen.

So können bei der Prozessierung dann auf der Vorderseite elektrische Strukturen, bevorzugt eine CMOS-Schaltungsstruktur ausgebildet werden, die einen oder mehrere Sensoren und/oder elektrisch ansteuerbare Elemente(3) darstellt.

Nach Fertigstellung von Strukturen auf der Vorderseite wird das Halbleitersubstrat nachfolgend an seiner Rückseite bearbeitet. Dabei wird die Dicke des Halbleitersubstrates von der Rückseite reduziert, bis die Vertiefungen auch an der Rückseite freigelegt sind und durch das Halbleitersubstrat hindurch reichende getrennte elektrische Potentiale bilden. Dies kann bevorzugt durch schleifen und/oder chemischmechanisches Polieren aber auch allein oder zusätzlich durch Ätzen erreicht werden.

Das Halbleitersubstrat hat dann beispielsweise eine Dicke von mindestens 200 µm, bevorzugt von ca. 250 µm. Die so erhaltenen Durchbrechungen sind ebenfalls frei von Absätzen sich konisch verjüngend oder ihre Innenwände zumindest nahezu orthogonal zur Oberfläche der Vorderseite ebenfalls absatzfrei ausgebildet, mit dotiertem Polysilizium, die äußere Durchbrechung ggf. mit einem weiteren dielektrischen Stoff vollständig ausgefüllt und das Spaltmaß kann an der Rückseite mindestens 50 % des Spaltmaßes an der Vorderseite betragen.

So sollte an der Vorderseite ein Spaltmaß von mindestens 5 µm, bevorzugt mindestens 8 µm eingehalten sein, so dass das Spaltmaß an der Rückseite dann mindestens 4 µm betragen kann.

Ein so in seiner Dicke reduziertes Halbleitersubstrat kann dann auf der Rückseite mit elektrischen Kontaktelementen versehen werden. Die Kontaktelemente sind im Wesentlichen mit dem in innen angeordneten Durchbrechungen ausgefüllten dotierten Polysilizium, als elektrisch leitendem Stoff, elektrisch leitend verbunden, was beispielsweise mittels einer entsprechend strukturierten "Under-Bump-Metallisierung (UBM)" erreichbar ist. Es können weitere Kontaktelemente ausgebildet bzw. angeschlossen und an der Rückseite undefinierte Potentiale vermieden werden. Es ist auch möglich die Rückseite mit einer isolierenden Beschichtung vollflächig zu versehen und Kontaktelemente frei zulegen.

Kontaktelemente können lokal definiert auf der Rückseite platziert werden. Auf der elektrisch isolierenden Beschichtung können elektrisch leitende Verbindungen ausgebildet werden.

Mit einem so gefertigten Halbleitersubstrat können mit Sensoren elektrisch leitend verbunden und die jeweiligen Messsignale von Sensoren durch das Halbleitersubstrat hindurch auf entsprechende Elektronik-Hardware oder bei elektrisch ansteuerbaren Elementen von einer Elektronik auf letztere übertragen werden.

Die äußeren den Isolator eines Halbleitersubstrates bildenden Durchbrechungen, die dann ebenfalls z.B. mit dotiertem Polysilizium ausgefüllt sind, können an Erd- oder Massepotential angeschlossen werden, um undefinierte Potentiale (floating)zu vermeiden.

Das Polysilizium kann bevorzugt mit Phosphor, aber auch mit Bor, Arsen oder Aluminium dotiert und n- oder p-leitend sein.

Die Herstellung kann im Gegensatz zu bekannten Lösungen vollständig in einer Prozesskette, in der mit CMOS-Technologie gearbeitet wird, erfolgen, ohne dass die Gefahr einer Kontamination durch unerwünschte Stoffe in der genutzten Anlagentechnik besteht.

Mit der erfindungsgemäßen Lösung wird das thermische Budget einer CMOS-Prozessierung nicht beeinträchtigt, verändert oder überschritten.

Die elektrischen Parameter sind reproduzierbar und es kann eine erhöhte mechanische Festigkeit erreicht werden. Außerdem können durch geeignete Auswahl des elektrisch leitenden Stoffes, z.B. dotiertes Polysilizium auch mechanischen Spannungen im Halbleitersubstrat infolge von unterschiedlichen Wärmeausdehnungen vermieden zumindest jedoch reduziert werden.

Die geometrische Gestaltung der Durchbrechungen für Isolator und elektrisch leitende Verbindung ist in weiten Grenzen variabel, wobei letzteres auch auf die Anzahl und Anordnung von Durchbrechungen, die die elektrisch leitende Verbindung durch das Halbleitersubstrat bilden, zutrifft.

Mit an der Rückseite ausgebildeten Kontaktelementen können aber auch mindestens zwei z.B. Sensoren und/oder Aktuatoren elektrisch leitend miteinander verbunden und je nach Bedarf verschaltet werden.

Mit erfindungsgemäßen Halbleitersubstraten können Sensorelemente, Sensorarrays, CMOS-Bildsensorarrays, Displays, Arrays mit elektrisch aktiven Elementen, die auch von der Vorderseite (z.B. optisch) zugänglich sind, aber auch Kombinationen davon zur Verfügung gestellt werden. Es kann die gesamte Fläche der Vorderseite genutzt werden.

Nachfolgend soll die Erfindung beispielhaft näher erläutert werden.

Dabei zeigen:
- Figur 1: in schematischer Form eine Schnittdarstel- lung eines Silicium-Halbleitersubstrates mit sack- lochförmigen Vertiefungen;
- Figur 2: in schematischer Form eine Schnittdarstel- lung eines Silicium-Halbleitersubstrates mit einer elektrisch leitenden Verbindung und einem Isolator für ein Halbleitersub- strat;
- Figur 3: ein Schliffbild eines Silicium- Halbleitersubstrates mit einer von der Vor- derseite in dieses eingeätzten Vertiefung, die mit dotiertem Polysilicium ausgefüllt worden ist;
- Figur 4: eine Schrägansicht eines Silicium- Halbleitersubstrates mit insgesamt drei in das Silicium-Halbleitersubstrat eingeätzten Vertiefungen;
- Figur 5: eine Ansicht von oben auf ein Silicium- Halbleitersubstrat mit drei in dieses ein- geätzten Vertiefungen und
- Figur 6: Beispiele für geometrische Gestaltungen von Isolator und elektrisch leitende Verbindung bildende Durchbrechungen durch ein Silici- um-Halbleitersubstrat.

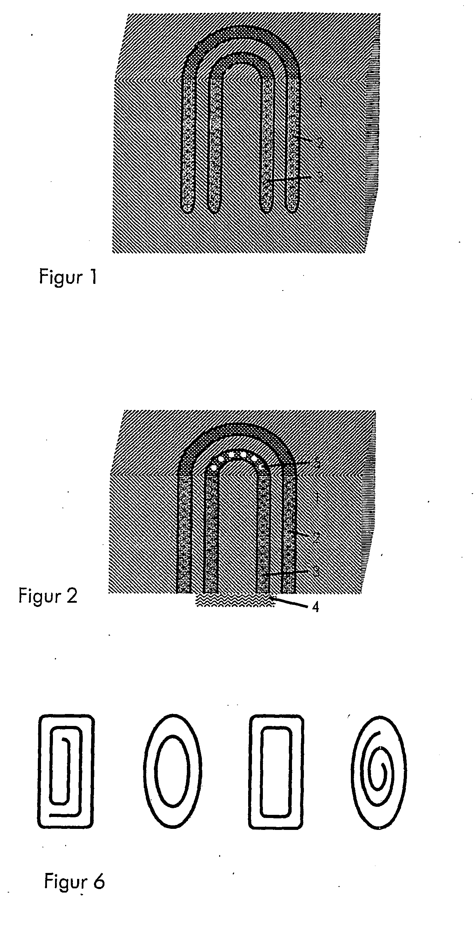

Figur 1 zeigt in schematischer Form ein Silicium-Halbleitersubstrat 1 mit in diesem ausgebildeten sacklockförmigen Vertiefungen, die nachfolgend nach dem Dünnen des Silicium-Halbleitersubstrates 1 die Durchbrechungen 2 und 3 bilden, wie dies nachfolgend noch genauer beschrieben werden soll.

Figur 2 zeigt in schematischer Form ein Beispiel für die Ausbildung einer elektrisch leitenden Verbindung durch ein Silicium-Halbleitersubstrat 1 und einen Isolator 2. Dabei wurden unter Verwendung einer entsprechend ausgebildeten Maske Vertiefungen mit einer Tiefe von mindestens 200 µm von der Vorderseite des Halbleitersubstrates 1 durch einen Plasmaätzprozess ausgebildet. Im Anschluss an die Ausbildung der Vertiefungen wurden diese mit dotiertem Polysilicium vollständig ausgefüllt, wobei vorab durch thermische Oxidation eine Siliciumoxidschicht an der Vorderseite und auch der Innenwand der Vertiefungen ausgebildet worden ist.

Nachfolgend wurde das in der innen angeordneten Vertiefung vorhandene dotierte Polysilicium an der oberen Stirnseite freigelegt, so dass eine elektrisch leitende Verbindung zum dotierten Polysilicium hergestellt werden kann.

Dies ist mit den weißen Punkten an der oberen Stirnseite angedeutet.

Ein so vorbereitetes Halbleitersubstrat 1 kann dann an der Vorderseite weiter prozessiert werden und z.B. eine CMOS-Schaltung ausgebildet werden (nicht dargestellt).

Nachfolgend kann dann das Halbleitersubstrat 1 an seiner Rückseite bearbeitet werden. Dabei wird die gesamte Dicke des Halbleitersubstrates 1 durch chemisches und mechanisches Polieren und/oder Schleifen so weit reduziert, bis die unteren Stirnseiten der Vertiefungen freigelegt sind und diese dann die Durchbrechungen 2 und 3 durch das Halbleitersubstrat 1 bilden.

Die bei diesem als äußere geschlossene Ringstruktur ausgebildete Durchbrechung 2 stellt dann den Isolator und die im Inneren der Durchbrechung 2 ebenfalls in Ringform ausgebildete Durchbrechung 3, die elektrisch leitende Verbindung dar. Die Isolationswirkung wird dabei ausschließlich durch die Oxidschicht an der äußeren Innenwand der äußeren Durchbrechung 2 erreicht.

An der Rückseite des Halbleitersubstrates 1 wurde dann durch eine Metallisierung ein elektrisches Kontaktelement 4 ausgebildet, dass mit den unteren Stirnseiten des in der innen angeordneten Durchbrechung 3 vorhandenen dotierten Polysilicium direkt elektrisch leitend und wie hier gezeigt im Inneren Teilbereich mit dem Halbleitersubstrat 1 kontaktiert ist.

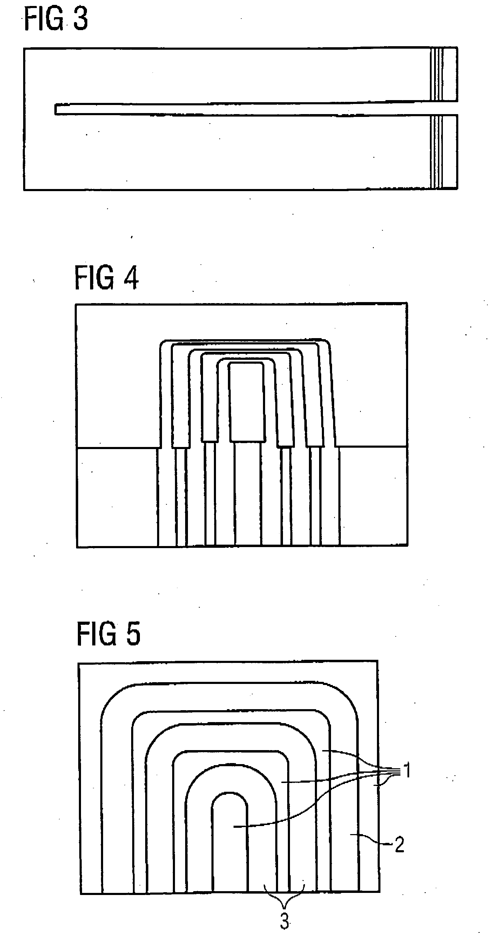

Mit Figur 3 ist eine durch Ätzen in ein Halbleitersubstrat 1 ausgebildete Vertiefung mit einer Ätztiefe von 250 µm in natura an einem Silicium-Halbleitersubstrat 1 gezeigt, die bereits vollständig mit dotiertem Polysilicium gefüllt worden ist.

Dabei wird deutlich, dass diese Vertiefung ein "Sackloch" in das Halbleitersubstrat bildet und ausgehend von der Vorderseite des Halbleitersubstrates 1 sich kontinuierlich konisch verjüngend ausgebildet ist.

In Figur 4 ist in einer Schrägansicht ein weiteres

### Beispiel gezeigt.

Dabei sind insgesamt drei Vertiefungen, für Durchbrechungen 2 und 3 durch ein Halbleitersubstrat 1 ausgebildet worden.

Die äußere Vertiefung, bildet dann am fertigen Halbleitersubstrat 1 eine den inneren Bereich vollständig umschließenden Isolator und mit den beiden in dessen Inneren angeordneten Durchbrechungen 3 kann die elektrisch leitende Verbindung von der Vorderseite zur Rückseite des Halbleitersubstrates 1 hergestellt werden, wobei der elektrische Stromfluss im Wesentlichen durch das die Durchbrechungen 3 ausfüllende dotierte Polysilicium gewährleistet ist.

Figur 5 zeigt in einer Teilansicht von oben eine Halbleitersubstratoberfläche nach dem Verfüllen und Planarisieren der Vertiefungen.

In Figur 6 sind mögliche Beispiele mit geometrischen Gestaltungen für Durchbrechungen 2 und 3 an einem Halbleitersubstrat 1 dargestellt.

Dabei bildet die jeweilige äußere Durchbrechung 2 eine in sich geschlossene Struktur die den inneren Bereich vollständig umschließt, so dass der innere Bereich gegenüber dem äußeren Bereich des Halbleitersubstrates 1 elektrisch isoliert ist.

Die im Inneren angeordneten Durchbrechungen 3 können je nach Bedarf und dementsprechend weitestgehend beliebig geometrisch, zum Beispiel konzentrisch geschlossen, archimedisch gewickelt, gefaltet oder mäanderförmig sein. Auch die Anzahl der innen angeordneten Durchbrechungen 3 kann frei gewählt werden.

## Patentansprüche

1. Halbleitersubstrat, bei dem eine elektrisch leitende Verbindung von seiner Vorderseite durch das Halbleitersubstrat (1) hindurch bis zu seiner Rückseite geführt und
die elektrisch leitende Verbindung von einem Isolator außen vollständig umschlossen ist, dabei
der Isolator mit einer Durchbrechung (2), die durch das Halbleitersubstrat (1) geführt und mit einem Stoff ausgefüllt ist, gebildet ist, wobei
die Innenwandung der Durchbrechung (2) mit einer dielektrischen Beschichtung versehen und die Durchbrechung mit einem elektrisch leitenden Stoff ausgefüllt ist,
die elektrisch leitende Verbindung mit mindestens einer weiteren Durchbrechung (3), die im Inneren des Isolators angeordnet, durch das Halbleitersubstrat (1) hindurch und mit einem elektrisch leitenden Stoff ausgefüllt ist, gebildet ist,
und
die Durchbrechungen (2, 3) ausgehend von der Vorderseite des Halbleitersubstrates (1) bis hin zur Rückseite absatzfreie orthogonal zur vorderseite ausgerichtete bzw. sich kontinuierlich in Richtung auf die Rückseite verjüngende Innenwände aufweisen.

2. Halbleitersubstrat nach Anspruch 1, **dadurch gekennzeichnet, dass** die die elektrisch leitende Verbindung bildende(n) Durchbrechung(en) (3) mit einem elektrisch leitenden Stoff ausgefüllt und an ihrer oberen Stirnseite mit einem Sensorelement und an ihrer rückseitigen Stirnseite mit einem Kontaktelement (4) elektrisch leitend verbunden ist/sind.

3. Halbleitersubstrat nach Anspruch 1 oder 2, **dadurch gekennzeichnet, dass** die Vorderseite des Halbleitersubstrates (1) mit einer elektrisch isolierenden Beschichtung versehen ist, durch die mindestens eine elektrisch leitende Verbindung zur oberen Stirnseite der Durchbrechung(en) (3) zum elektrisch leitenden Stoff geführt ist.

4. Halbleitersubstrat nach einem der vorhergehenden Ansprüche, **dadurch gekennzeichnet, dass** die den Isolator bildende Durchbrechung (2) mit einem elektrisch leitenden Stoff ausgefüllt und an Erd- oder Massepotential angeschlossen ist.

5. Halbleitersubstrat nach einem der vorhergehenden Ansprüche, **dadurch gekennzeichnet, dass** das Substrat (1) eine Dicke von mindestens 200 µm aufweist und die Durchbrechungen (2, 3) ausgehend von der Vorderseite bis zur Rückseite geführt sind.

6. Halbleitersubstrat nach einem der vorhergehenden Ansprüche, **dadurch gekennzeichnet, dass** das Spaltmaß der Durchbrechungen (2, 3) an der Rückseite des Substrates (1) mindestens 50 % des Spaltmaßes an der Vorderseite des Substrates (1) beträgt.

7. Halbleitersubstrat nach Anspruch 6, **dadurch gekennzeichnet, dass** das Spaltmaß an der Vorderseite mindestens 5 µm beträgt.

8. Halbleitersubstrat nach einem der vorhergehenden Ansprüche, **dadurch gekennzeichnet, dass** auf der Vorderseite eine CMOS-Schaltungsstruktur ausgebildet und mit mindestens einer elektrisch leitenden Verbindung durch das Halbleitersubstrat (1) kontaktiert ist.

9. Halbleitersubstrat nach einem der vorhergehenden Ansprüche, **dadurch gekennzeichnet, dass** eine elektrisch leitende Verbindung durch das Halbleitersubstrat (1) an dessen Vorderseite mit einem elektrisch ansteuerbaren Element oder Kontaktelement kontaktiert ist.

10. Halbleitersubstrat nach einem der vorhergehenden Ansprüche, **dadurch gekennzeichnet, dass** Silizium Substratwerkstoff und dotiertes Polysilizium elektrisch leitender Stoff sind.

11. Halbleitersubstrat nach einem der vorhergehenden Ansprüche, **dadurch gekennzeichnet, dass** mit einer Vielzahl durch das Halbleitersubstrat (1) geführten elektrisch leitenden Verbindungen ein Array mit elektrisch ansteuerbaren und/oder Sensorelementen gebildet ist.

12. Halbleitersubstrat nach einem der vorhergehenden Ansprüche, **dadurch gekennzeichnet, dass** es als Sensorelement, Sensorarray, CMOS-Bildsensorarray, Display und/oder Array mit elektrisch aktiven Elementen ausgebildet ist.

13. Verfahren zur Herstellung von Halbleitersubstraten, bei denen eine elektrisch leitende Verbindung von einer Vorderseite des Halbleitesubstrates (1) durch das Halbleitersubstrat (1) hindurch bis zu seiner Rückseite geführt ist,
dabei in das Halbleitersubstrat (1) mindestens zwei Vertiefungen mit absatzfreien Innenwänden von der Vorderseite des Halbleitersubstrates (1) mit einer vorgebbaren Mindesttiefe durch ein Ätzverfahren, so ausgebildet werden, dass mindestens eine innere Vertiefung von einer äußeren Vertiefung vollständig umschlossen ist, dann
die Innenwand der äußeren Vertiefung vollflächig mit einer elektrisch isolierenden Beschichtung versehen und einem elektrisch leitenden Stoff ausgefüllt wird; und
die innere (n) Vertiefung(en) vollständig mit einem elektrisch leitenden Stoff ausgefüllt oder vollflächig mit einer elektrisch isolierenden Beschichtung versehen und mit einem elektrisch leitenden Stoff befüllt wird/werden,
anschließend ausgehend von der Rückseite des Halbleitersubstrates (1) dessen Dicke reduziert wird, bis die rückseitigen Stirnseiten der ausgefüllten Vertiefungen freigelegt sind und die äußere Vertiefung als ausgefüllte Durchbrechung (2) durch das Halbleitersubstrat (1) einen Isolator und die innere(n) Vertiefung (en), als ausgefüllte Durchbrechung(en) (3) eine elektrisch leitende Verbindung bilden.

14. Verfahren nach Anspruch 13, **dadurch gekennzeichnet, dass** ein Kontaktelement (4) elektrisch leitend mit dem freigelegten elektrisch leitenden Stoff in der/den innen angeordneten Durchbrechung(en) (3) an der Rückseite des Halbleitersubstrates (1) kontaktiert wird.

15. Verfahren nach Anspruch 13 oder 14, **dadurch gekennzeichnet, dass** die Reduzierung der Dicke des Halbleitersubstrates (1) durch schleifen, chemisch-mechanisches Polieren und/oder ein Ätzverfahren durchgeführt wird.

16. Verfahren nach einem der Ansprüche 13 bis 15, **dadurch gekennzeichnet, dass** die elektrisch isolierende Beschichtung durch Oxidation von Silizium als Substratwerkstoff ausgebildet wird.

17. Verfahren nach einem der Ansprüche 13 bis 16, **dadurch gekennzeichnet, dass** vor der Reduzierung der Dicke des Halbleitersubstrates (1) der elektrisch leitende Stoff in der/den inneren Vertiefung(en) an der Vorderseite zumindest bereichsweise freigelegt und mit einer elektrisch leitenden Schicht oder einem Kontaktelement verbunden wird.

18. Verfahren nach einem der Ansprüche 13 bis 17, **dadurch gekennzeichnet, dass** auf der Vorderseite eine CMOS-Schaltungsstruktur nach Ausbildung der elektrisch leitenden Verbindung durch das Halbleitersubstrat ausgebildet wird.

19. Verfahren nach einem der Ansprüche 13 bis 18, **dadurch gekennzeichnet, dass** auf der Vorderseite des Halbleitersubstrates (1) mehrere Sensorelemente elektrisch leitend verbunden werden und ein Sensorarrayelement hergestellt wird.

20. Verfahren nach einem der Ansprüche 13 bis 19, **dadurch gekennzeichnet, dass** auf der Vorderseite des Halbleitersubstrates (1) mehrere elektrisch ansteuerbare Elemente elektrisch leitend verbunden werden und ein mit elektrisch ansteuerbaren Elementen bestücktes Array hergestellt wird.

## Claims

1. Semiconductor substrate, in which an electrically conductive connection is led from its front side through the semiconductor substrate (1) to its rear side and
the electrically conductive connection is completely enclosed on the outside by an insulator,
the insulator being formed with an opening (2) which is led through the semiconductor substrate (1) and filled with a material,
the inner wall of the opening (2) being provided with a dielectric coating and the opening being filled with an electrically conductive material,
the electrically conductive connection being formed with at least one further opening (3) which is arranged inside the insulator, through the semiconductor substrate (1), and is filled with an electrically conductive material, and
the openings (2, 3) having inner walls which, from the front side of the semiconductor substrate (1) to the rear side, are free from steps and oriented orthogonally to the front side or taper continuously in the direction of the rear side.

2. Semiconductor substrate according to Claim 1, **characterised in that** the opening(s) (3) forming the electrically conductive connection is/are filled with an electrically conductive material and is/are electrically conductively connected at its/their upper end side to a sensor element and at its/their rear end side to a contact element (4).

3. Semiconductor substrate according to Claim 1 or 2, **characterised in that** the front side of the semiconductor substrate (1) is provided with an electrically insulating coating, through which at least one electrically conductive connection is led to the upper end side of the opening(s) (3) to the electrically conductive material.

4. Semiconductor substrate according to one of the preceding claims, **characterised in that** the opening (2) forming the insulator is filled with an electrically conductive material and connected to earth potential or frame potential.

5. Semiconductor substrate according to one of the preceding claims, **characterised in that** the substrate (1) has a thickness of at least 200 µm and the openings (2, 3) are led from the front side to the rear side.

6. Semiconductor substrate according to one of the preceding claims, **characterised in that** the gap size of the openings (2, 3) at the rear side of the substrate (1) is at least 50% of the gap size at the front side of the substrate (1).

7. Semiconductor substrate according to Claim 6, **characterised in that** the gap size at the front side is at least 5 µm.

8. Semiconductor substrate according to one of the preceding claims, **characterised in that** a CMOS circuit structure is formed on the front side and is contacted with at least one electrically conductive connection through the semiconductor substrate (1).

9. Semiconductor substrate according to one of the preceding claims, **characterised in that** an electrically conductive connection through the semiconductor substrate (1) is contacted at its front side with an electrically drivable element or contact element.

10. Semiconductor substrate according to one of the preceding claims, **characterised in that** silicon is the substrate material and doped polysilicon is the electrically conductive material.

11. Semiconductor substrate according to one of the preceding claims, **characterised in that** an array with electrically drivable and/or sensor elements is formed by a multiplicity of electrically conductive connections led through the semiconductor substrate (1).

12. Semiconductor substrate according to one of the preceding claims, **characterised in that** it is formed as a sensor element, a sensor array, a CMOS image sensor array, a display and/or an array with electrically active elements.

13. Method for producing semiconductor substrates, in which substrates an electrically conductive connection is led from a front side of the semiconductor substrate (1) through the semiconductor substrate (1) to its rear side,
at least two indentations being formed with step-free inner walls in the semiconductor substrate (1), from the front side of the semiconductor substrate (1), with a predeterminable minimum depth by an etching process, in such a way that at least one inner indentation is completely enclosed by an outer indentation, then
the inner wall of the outer indentation being provided over the entire surface with an electrically insulating coating and filled with an electrically conductive material; and
the inner indentation(s) being completely filled with an electrically conductive material or provided over the entire surface with an electrically insulating coating and filled with an electrically conductive material,
subsequently, starting from the rear side of the semiconductor substrate (1), the thickness of the latter being reduced until the rear end sides of the filled indentations are exposed and the outer indentation forms, as a filled opening (2) through the semiconductor substrate (1), an insulator and the inner indentation(s) forms(form), as a filled opening(filled openings) (3), an electrically conductive connection.

14. Method according to Claim 13, **characterised in that** a contact element (4) is electrically conductively contacted with the exposed electrically conductive material in the inner-arranged opening(s) (3) at the rear side of the semiconductor substrate (1).

15. Method according to Claim 13 or 14, **characterised in that** the reduction of the thickness of the semiconductor substrate (1) is carried out by grinding, chemical-mechanical polishing and/or an etching process.

16. Method according to one of Claims 13 to 15, **characterised in that** the electrically insulating coating is formed by oxidation of silicon as the substrate material.

17. Method according to one of Claims 13 to 16, **characterised in that**, before the reduction of the thickness of the semiconductor substrate (1), the electrically conductive material in the inner indentation(s) is exposed at the front side at least in regions and is connected to an electrically conductive layer or a contact element.

18. Method according to one of Claims 13 to 17, **characterised in that** a CMOS circuit structure is formed on the front side after formation of the electrically conductive connection through the semiconductor substrate.

19. Method according to one of Claims 13 to 18, **characterised in that** a plurality of sensor elements are electrically conductively connected on the front side of the semiconductor substrate (1) and a sensor array element is produced.

20. Method according to one of Claims 13 to 19, **characterised in that** a plurality of electrically drivable elements are electrically conductively connected on the front side of the semiconductor substrate (1) and an array equipped with electrically drivable elements is produced.

## Revendications

1. Substrat semi-conducteur, dans lequel une liaison électroconductrice est guidée à travers le substrat semi-conducteur (1) depuis la face avant de celui-ci jusque sur la face arrière de celui-ci, et
la liaison électroconductrice est entourée totalement de l'extérieur par un isolateur,
ledit isolateur est formé avec un passage (2) qui est guidé à travers le substrat semi-conducteur (1) et est comblé par une matière,
la paroi intérieure du passage (2) étant revêtue d'un revêtement diélectrique et le passage étant comblé par une matière électroconductrice,
la liaison électroconductrice est formée avec au moins un passage (3) supplémentaire, qui est disposé à l'intérieur de l'isolateur, passe à travers le substrat semi-conducteur (1) et est comblé par une matière électroconductrice,
et
les passages (2, 3) comportent, depuis la face avant du substrat semi-conducteur (1) jusqu'à la face arrière, des parois intérieures, sans décrochement par rapport à la face arrière, orientées orthogonalement par rapport à la face avant et se rétrécissant en continu vers la face arrière.

2. Substrat semi-conducteur selon la revendication 1, **caractérisé en ce que** le/les passage(s) (3) formant la liaison électroconductrice est/sont comblé(s) par une matière électroconductrice et est/sont relié(s) de manière électroconductrice à un élément capteur sur sa/leur face frontale supérieure et à un élément de contact (4) sur sa/leur face frontale arrière.

3. Substrat semi-conducteur selon la revendication 1 ou 2, **caractérisé en ce que** la face avant du substrat semi-conducteur (1) est revêtue d'un revêtement électro-isolant, à travers lequel est guidée au moins une liaison électroconductrice vers la face frontale supérieure du/des passage(s) (3) vers la matière électroconductrice.

4. Substrat semi-conducteur selon l'une quelconque des revendications précédentes, **caractérisé en ce que** le passage (2) formant l'isolateur est comblé par une matière électroconductrice et est raccordé au potentiel de la terre ou au potentiel de la masse.

5. Substrat semi-conducteur selon l'une quelconque des revendications précédentes, **caractérisé en ce que** le substrat (1) a une épaisseur de 200 µm au moins et les passages (2, 3) sont guidés depuis la face avant jusqu'à la face arrière.

6. Substrat semi-conducteur selon l'une quelconque des revendications précédentes, **caractérisé en ce que** la dimension de la fente formée par les passages (2, 3) sur la face arrière du substrat (1) est égale à au moins 50 % de la dimension de la fente sur la face avant du substrat (1).

7. Substrat semi-conducteur selon la revendication 6, **caractérisé en ce que** la fente sur la face avant mesure au moins 5 µm.

8. Substrat semi-conducteur selon l'une quelconque des revendications précédentes, **caractérisé en ce qu'**une structure de commutation CMOS est réalisée sur la face avant et est mise en contact avec au moins une liaison électroconductrice à travers le substrat semi-conducteur (1).

9. Substrat semi-conducteur selon l'une quelconque des revendications précédentes, **caractérisé en ce qu'**une liaison électroconductrice traversant le substrat semi-conducteur (1) est mise en contact sur la face avant de celui-ci avec un élément actionnable électriquement ou un élément de contact.

10. Substrat semi-conducteur selon l'une quelconque des revendications précédentes, **caractérisé en ce que** le matériau du substrat est le silicium et la matière électroconductrice est un polysilicium dopé.

11. Substrat semi-conducteur selon l'une quelconque des revendications précédentes, **caractérisé en ce qu'**un réseau d'éléments actionnables électriquement et/ou d'éléments capteurs est formé par une pluralité de liaisons électroconductrices guidées à travers le substrat semi-conducteur (1).

12. Substrat semi-conducteur selon l'une quelconque des revendications précédentes, **caractérisé en ce qu'**il est réalisé sous la forme d'un élément capteur, d'un réseau de capteurs, d'un réseau de capteurs d'images CMOS, d'un afficheur et/ou d'un réseau avec des éléments électriquement actifs.

13. Procédé de réalisation de substrats semi-conducteurs, dans lesquels une liaison électroconductrice est guidée à travers le substrat semi-conducteur (1) depuis la face avant de celui-ci jusque sur la face arrière de celui-ci,
au moins deux creux avec des parois intérieures sans décrochement sont réalisés dans le substrat semi-conducteur (1) au moyen d'un procédé de gravure à partir de la face avant du substrat semi-conducteur (1) avec une profondeur minimum prédéfinissable, de telle sorte qu'au moins un creux intérieur est entièrement entouré par un creux extérieur, ensuite
la paroi intérieure du creux extérieur est entièrement revêtue d'un revêtement électro-isolant et est comblé par une matière électroconductrice ; et
le/les creux intérieur(s) est/sont entièrement comblé(s) par une matière électroconductrice ou est/sont revêtu(s) sur toute leur surface par un revêtement électro-isolant et est/sont comblé(s) par une matière électroconductrice,
ensuite, l'épaisseur du substrat semi-conducteur (1) est diminuée en partant de la face arrière de celui-ci, jusqu'à ce que les faces frontales arrière des creux comblés soient dégagées, et le creux extérieur en tant que passage (2) comblé traversant le substrat semi-conducteur (1) forme un isolateur et le/les creux intérieur(s), en tant que passage(s) (3) comblé(s), forme(nt) une liaison électroconductrice.

14. Procédé selon la revendication 13, **caractérisé en ce qu'**un élément de contact (4) est mis en contact de manière électroconductrice sur la face arrière du substrat semi-conducteur (1) avec la matière électroconductrice dégagée dans le/les passage(s) (3) disposé(s) à l'intérieur.

15. Procédé selon la revendication 13 ou 14, **caractérisé en ce que** la diminution de l'épaisseur du substrat semi-conducteur (1) est réalisée par meulage, polissage chimico-mécanique et/ou par un procédé de gravure.

16. Procédé selon l'une quelconque des revendications 13 à 15, **caractérisé en ce que** le revêtement électro-isolant est réalisé par l'oxydation du silicium, formant le matériau du substrat.

17. Procédé selon l'une quelconque des revendications 13 à 16, **caractérisé en ce que**, avant la diminution de l'épaisseur du substrat semi-conducteur (1), la matière électroconductrice dans le/les creux intérieur(s) est dégagée au moins par zones sur la face avant et est reliée à une couche électroconductrice ou à un élément de contact.

18. Procédé selon l'une quelconque des revendications 13 à 17, **caractérisé en ce que**, après la réalisation de la liaison électroconductrice à travers le substrat semi-conducteur, une structure de commutation CMOS est réalisée sur la face avant.

19. Procédé selon l'une quelconque des revendications 13 à 18, **caractérisé en ce que** sur la face avant du substrat semi-conducteur (1), plusieurs éléments capteurs sont reliés de manière électroconductrice et il est réalisé un élément de réseau de capteurs.

20. Procédé selon l'une quelconque des revendications 13 à 19, **caractérisé en ce que** sur la face avant du substrat semi-conducteur (1), plusieurs éléments actionnables électriquement sont reliés de manière électroconductrice et il est réalisé un réseau muni d'éléments actionnables électriquement.
